# EUROPÄISCHE PATENTANMELDUNG

(11) **EP 3 067 707 A1**
(43) Veröffentlichungstag der Anmeldung: **14.09.2016**
(21) Anmeldenummer: 16156643.5
(22) Anmeldetag: 22.02.2016
(51) Int. Cl.: G01R 31/28, H01R 13/646

(54) **GBIT-SCHNITTSTELLENADAPTER ZUM ADAPTIEREN VON GBIT-SCHNITTSTELLEN WÄHREND EINES LEITUNGSTESTS EINES HOCHGESCHWINDIGKEITSBUSSES EINES PRÜFOBJEKTS AN EINE PRÜFEINRICHTUNG**

(30) Priorität: 23.02.2015 DE 102015102531
(71) Anmelder: Göpel electronic GmbH, 07745 Jena (DE)
(72) Erfinder: BUSSE, Hosea Lukas, 07743 Jena (DE); HAUBOLD, Sven, 07745 Jena (DE)
(74) Vertreter: Oehmke, Volker

(57) **Zusammenfassung**

Aufgabe der Erfindung ist es, eine Möglichkeit für einen einfachen, leicht austauschbaren Adapter zur Prüfung der Gbit-Busverbindungen mit individuellen Schnittstellen auf Fertigungsfehler und dynamische Beeinflussungen zu finden, der den speziellen Anforderungen der hohen Taktraten gerecht wird.

Erfindungsgemäß wird die Aufgabe mit einem Gbit-Schnittstellenadapter zum Adaptieren von Gbit-Schnittstellen während eines Leitungstests eines Hochgeschwindigkeitsbusses eines Prüfobjekts an eine Prüfeinrichtung, enthaltend einen Träger mit einer Vielzahl mit Schnittstellen der Prüfeinrichtung verbindbarer elektrischer Kontakte als eine frei konfigurierbare Schnittstelle und mit einer den Kontakten des zu prüfenden Prüfobjekts entsprechenden Anzahl elektrischer Kontakte, wobei der Schnittstellenadapter eine Vielzahl von Busverbindungsleitungen zwischen der frei konfigurierbaren Schnittstelle und den elektrischen Kontakten zur Anbindung des Prüfobjekts aufweist, dadurch gelöst, dass die Vielzahl der Busverbindungsleitungen des Schnittstellenadapters eine festgelegte, genau spezifizierte Leitungseigenschaften aufweisende Verbindung zwischen der frei konfigurierbaren Schnittstelle und einer individuellen Schnittstelle mit einer Anzahl der dem Prüfobjekt entsprechenden elektrischen Kontakte herstellend auf dem Träger angeordnet sind.

## Beschreibung

Die Erfindung betrifft einen Gbit-Schnittstellenadapter für Hochgeschwindigkeits-Bussysteme.

Die hohe Integrationsdichte und Komplexität von integrierten Schaltungen oder elektronischen Baugruppen auf bestückten Leiterplatten mit ihren zahlreichen Bauelementen, Leitern und deren Verbindungen erhöhen auch das Risiko des Auftretens potenzieller Fehler. Für die Qualitätssicherung ist es daher unerlässlich, die elektronischen Schaltungen mit geeigneten Tests zu überprüfen. Zur Prüfung von integrierten Schaltungen oder Leiterplatten existieren eine Reihe standardisierter Testverfahren, wie beispielsweise der In-Circuit-Test oder der Boundary Scan, für die in der Regel individuelle Adapter erforderlich sind.

Beim In-Circuit-Test werden bei bestückten Leiterplatten neben der Überprüfung ganzer Schaltungsblöcke auch Fehler der elektrischen Verbindungen auf der Leiterplatte erfasst bzw. Fehlerursachen aufgedeckt. Für den In-Circuit-Test sind in der Regel speziell auf die Leiterplatten angepasste Nadeladapter erforderlich, mit denen die Leiterplatte kontaktiert wird und welche die Verbindung zum Prüfsystem herstellen.

Eine Adaptierung des Prüflings mit Nadeladapter ist auch beim Boundary-Scan-Test erforderlich. Dabei wird allerdings nur eine vergleichsweise geringe Anzahl von Nadeln benötigt, um die nach dem IEEE1149.x-Standard benötigten Signale zum Prüfling zu führen. Für den Test sind spezielle Kontakte vorgesehen, durch die der Zugang mit dem Nadeladapter zum Prüfobjekt auch noch bei höher integrierten Schaltungen ermöglicht wird. Durch den im IEEE-Standard 1149.1 festgelegten Funktionsumfang wird ebenfalls das Erfassen und Lokalisieren von Fehlern ermöglicht.

Das Prüfen von Hochgeschwindigkeits-Bussystemen, wie beispielsweise USB 3.0, SATA oder PCIe, wird durch die Vielzahl existierender Schnittstellen erschwert. Dabei besteht sowohl zwischen den Bussystemen als auch innerhalb des gleichen Bussystems eine erhebliche Vielfalt an Schnittstellen. Die individuellen Lösungen können sich in Bauform, Stromversorgung und in verwendeten Zusatzsignalen unterscheiden, sodass Prüfsysteme eine Vielzahl unterschiedlichster Schnittstellen vorhalten müssten, um alle Tests mit einem Prüfsystem ausführen zu können. Um diesen Aufwand zu umgehen, ist der Einsatz von Adaptern unumgänglich. Wegen der Dämpfung an jeder Adapterverbindung und der hohen Empfindlichkeit gegenüber Störeinflüssen unterliegt die Verwendung von Adaptern bei Hochgeschwindigkeits-Bussystemen jedoch starken Einschränkungen. Hinzu kommt, dass die Spezifikationen mancher Steckverbinder nur eine begrenzte Anzahl von Steckzyklen zulassen.

In der Offenlegungsschrift DE 101 18 206 A1 ist ein Prüfsystem zum Prüfen von Halbleiter-Bauteilen offenbart. Das Prüfsystem (hier Prüfkopf) weist mindestens zwei unabhängig voneinander zu betreibende, austauschbare Prüfgerätmodule mit jeweils einer Schnittstelle zu einer Prüfgeräthalterung auf. Diese Schnittstelle weist standardisierte Spezifikationen auf, sodass die Austauschbarkeit der Prüfgerätmodule ermöglicht wird. Erst die Prüfgeräthalterung ist für die spezifische Anpassung des Prüfsystems an das Prüfobjekt und an die Prüfanwendung vorgesehen und ist dementsprechend konstruiert bzw. verfügt über dementsprechende Mittel. Das Prüfobjekt ist in einem Stecksockel auf einem Adapter (hier ein Performance-Board) aufgenommen. Die Verbindung zwischen dem Adapter und dem Prüfsystem erfolgt über gefederte Kontakte, die in großer Anzahl auf der Prüfgeräthalterung angeordnet sind. Ein Hinweis auf die Verwendung des Prüfsystems bei hohen Taktraten wird in der zuvor genannten Schrift nicht gegeben und wird durch die mehr als zwei Schnittstellen zwischen Prüfsystem und Prüfobjekt auch nicht begünstigt.

Eine in der Gebrauchsmusterschrift DE 84 27 884 U1 offenbarte Einrichtung zur Funktionsprüfung eines elektronischen Prüfobjekts, hier anhand eines integrierten Schaltkreises (IC) beschrieben, verfügt über baugleiche Testköpfe eines Prüfsystems (hier ein Hauptrechner, der den Prüfablauf steuert) zum Anschluss des zu prüfenden IC. Die Testköpfe verfügen über jeweils gleichartige Anschlussfelder mit im Raster angeordneten federnden Kontaktnadeln. Die Verbindung zwischen dem Prüfsystem und dem IC wird über einen Adapter hergestellt, der zu einer Seite über entsprechend den Anschlussfeldern angeordnete Anschlusskontakte und zur anderen Seite über eine Steckfassung zur Aufnahme des IC verfügt. Der Adapter ermöglicht, dass mit dem gleichen Prüfsystem ICs mit unterschiedlicher Anzahl an Anschlüssen geprüft werden können. Je nach Anschlusszahl des IC wird der Adapter so ausgelegt, dass er die Verbindung zu nur einem Kontaktfeld oder, wenn erforderlich, auch zu mehreren Kontaktfeldern herstellen kann. Eine weitere Spezifikation des Adapters erfolgt nicht, sodass davon ausgegangen werden kann, dass die Kombination aus Prüfsystem und Adapter nicht zum Prüfen von Gbit-Schnittstellen geeignet ist.

Die hohe Taktrate bei Hochgeschwindigkeits-Bussystemen stellt an die Adapter besonders hohe Anforderungen, um bei einer Datenübertragung die Signalintegrität zu erhalten. Wegen der an jeder Schnittstelle entstehenden Dämpfung und der Empfindlichkeit gegenüber Störeinflüssen sollte die Anzahl der Schnittstellen (z. B. Steckverbinder) generell so gering wie möglich gehalten werden. Typischerweise hat sich eine Begrenzung auf maximal drei Schnittstellen zwischen Prüfsystem und Prüfobjekt bewährt.

Aufgabe der Erfindung ist es, eine Möglichkeit für einen einfachen, leicht austauschbaren Adapter zur Prüfung der Gbit-Busverbindungen mit individuellen Schnittstellen auf Fertigungsfehler und dynamische Beeinflussungen zu finden, der den speziellen Anforderungen der hohen Taktraten gerecht wird.

Erfindungsgemäß wird die Aufgabe mit einem Gbit-Schnittstellenadapter zum Adaptieren von Gbit-Schnittstellen während eines Leitungstests eines Hochgeschwindigkeitsbusses eines Prüfobjekts an eine Prüfeinrichtung, enthaltend einen Träger mit einer Vielzahl mit Schnittstellen der Prüfeinrichtung verbindbarer elektrischer Kontakte als eine frei konfigurierbare Schnittstelle und mit einer den Kontakten des zu prüfenden Prüfobjekts entsprechenden Anzahl elektrischer Kontakte, wobei der Schnittstellenadapter eine Vielzahl von Busverbindungsleitungen zwischen der frei konfigurierbaren Schnittstelle und den elektrischen Kontakten zur Anbindung des Prüfobjekts aufweist, dadurch gelöst, dass die Vielzahl der Busverbindungsleitungen des Schnittstellenadapters eine festgelegte, genau spezifizierte Leitungseigenschaften aufweisende Verbindung zwischen der frei konfigurierbaren Schnittstelle und einer individuellen Schnittstelle mit einer Anzahl der dem Prüfobjekt entsprechenden elektrischen Kontakte herstellend auf dem Träger angeordnet sind.

Vorteilhaft ist es, wenn der Schnittstellenadapter einen integrierten Signalverstärker zur Wahrung der Signalintegrität aufweist.

Die einzelnen Leitungen des Gbit-Schnittstellenadapters sollten vorteilhaft einen maximalen Leitungsimpedanzunterschied entsprechend eines die jeweilige Schnittstelle definierenden Standards aufweisen.

Von Vorteil ist es, wenn die Leitungen des Gbit-Schnittstellenadapters eine identische Länge aufweisen bzw. die maximalen Leitungslängenunterschiede entsprechend eines die jeweilige Schnittstelle definierenden Standards gewählt werden.

Ebenfalls von Vorteil ist es, wenn der Leitungsverlauf des Gbit-Schnittstellenadapters mit einem Design frei von Störquellen konzipiert wird.

Eine weitere vorteilhafte Ausgestaltung des Gbit-Schnittstellenadapters besteht darin, dass die Busverbindungsleitungen des Schnittstellenadapters als flexible Verbindung ausgeführt sind.

Von Vorteil kann es ferner sein, wenn die Busverbindungsleitungen des Gbit-Schnittstellenadapters zur Übertragung von Spannungen, Strömen, Daten oder Signalen genutzt werden können.

Der Gbit-Schnittstellenadapter ist dadurch gekennzeichnet, dass die individuelle Schnittstelle und die Busverbindungsleitungen mindestens den Erfordernissen des jeweiligen Standards, wie z. B. USB 3.0, SATA II oder PCIe Gen2, entsprechen.

Von Vorteil ist, wenn die frei konfigurierbare Schnittstelle eine parallele Erweiterungsmöglichkeit zur Erhöhung einer Busbandbreite aufweist.

Die Erfindung wird nachfolgend anhand von Ausführungsbeispielen und Abbildungen näher erläutert. Dabei zeigen:
- Fig. 1: eine Prinzipdarstellung eines Schnittstellenadapters in einem schematisch dargestellten Prüfaufbau zur Prüfung eines Hochgeschwindigkeitsbusses,
- Fig. 2: eine Ausführungsform des Schnittstellenadapters mit einem integrierten Signalverstärker,
- Fig. 3: eine Ausführungsform des Schnittstellenadapters mit einer erweiterten frei konfigurierbaren Schnittstelle,
- Fig. 4: eine Ausführungsform des Schnittstellenadapters mit flexibel ausgeführten Busverbindungsleitungen.

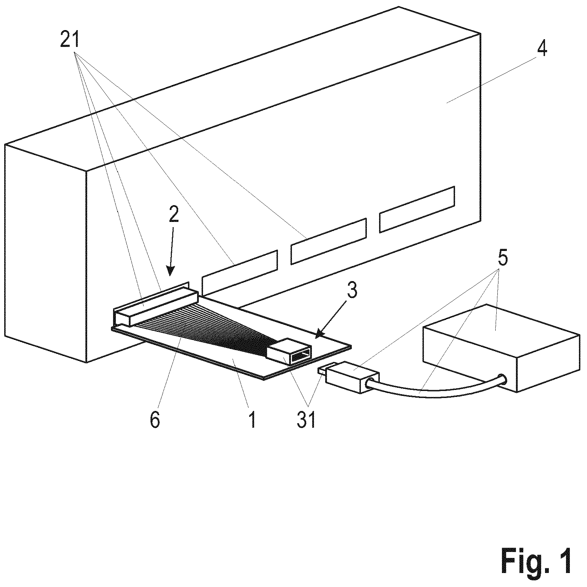

Der Schnittstellenadapter ist grundsätzlich wie in Fig. 1 gezeigt aufgebaut. Er weist einen Träger 1 auf, auf dem eine frei konfigurierbare Schnittstelle 2 und eine individuelle Schnittstelle 3 angeordnet sind. Die frei konfigurierbare Schnittstelle 2 verfügt über eine Vielzahl elektrischer Kontakte, die in mindestens einem Prüfeinrichtungssteckverbinder 21 zusammengefasst angeordnet sind. Mit dem Prüfeinrichtungssteckverbinder 21 wird der Schnittstellenadapter an einer Prüfeinrichtung 4 angeschlossen. Die individuelle Schnittstelle 3 verfügt über eine einem zu prüfenden Prüfobjekt 5 entsprechende Anzahl elektrischer Kontakte, die in einem Prüfobjektsteckverbinder 31 zusammengefasst angeordnet sind. Am Prüfobjektsteckverbinder 31 wird das Prüfobjekt 5 mit dem Schnittstellenadapter verbunden. Die elektrischen Kontakte der beiden Schnittstellen 2 und 3 sind über Busverbindungsleitungen 6 elektrisch und mechanisch fest verbunden. Die Busverbindungsleitungen 6 sind auf dem Träger 1 angeordnet.

Die Prüfeinrichtung 4 ist universell ausgelegt und kann alle möglichen und üblichen Signal- und Versorgungsleitungen bereitstellen. Die Signal- und Versorgungsleitungen werden über eine oder mehrere Schnittstellen der Prüfeinrichtung 4 nach außen geführt, wobei jede der Schnittstellen identisch aufgebaut und verschaltet ist. Zur Versorgung des Prüfobjekts 5 verfügt die Prüfeinrichtung 4 über Mittel zur Stromversorgung, die beispielsweise Versorgungsleitungen mit 2,5 V; 3,3 V; oder 5 V bereitstellen. Zur Prüfung von Hochgeschwindigkeits-Bussystemen werden über ein frei programmierbares FPGA (Field Programmable Gate Array) die folgenden Signale als eine Mindestbelegung bereit gestellt und mit den Schnittstellen der Prüfeinrichtung 4 verbunden:
- 4 serielle differentielle High-Speed-Transceiver-Signale
- 28 bidirektionale Single-Ended-Signale
- 1 Adapter-Detect-Signal
- 2 I²C-Signale zur Adapteridentifizierung oder für einfache Speicherzwecke
- 2 differentielle Referenztakt-Eingangssignale für die Gbit-Transceiver des FPGA

An den Schnittstellen der Prüfeinrichtung 4 werden die Prüfeinrichtungssteckverbinder 21 der mit den Prüfobjekten 5 verbindbaren Schnittstellenadapter angeschlossen. Über die Anordnung und Anzahl der Busverbindungsleitungen 6 auf dem Schnittstellenadapter wird die Kompatibilität der Prüfeinrichtung 4 zum Prüfobjekt 5 hergestellt. Dabei ist die Belegung der Schnittstelle des Prüfobjekts 5 ausschlaggebend. Das heißt, dass die elektrischen Kontakte der individuellen Schnittstelle 3 mit einer entsprechenden Anzahl an Busverbindungsleitungen 6 so an die frei konfigurierbare Schnittstelle 2 angeschlossen werden, dass alle erforderlichen Signal- und Versorgungsleitungen der Prüfeinrichtung 4 für die Prüfung zur Verfügung stehen.

Entsprechend den in Standards und Designrichtlinien festgelegten Erfordernissen der Hochgeschwindigkeits-Bussysteme mit Datenraten ≥ 1 Gbit sind die Busverbindungsleitungen 6 so angeordnet, dass mögliche Quellen für Signalverluste vermieden werden. Insbesondere sind HF-Störquellen, wie beispielsweise sich kreuzende Busverbindungsleitungen 6, Durchführungen durch Leiterplatten (Vias) oder andere scharfe Abbiegungen in den Busverbindungsleitungen 6, nicht zugelassen. Weiterhin sind die Längen der Busverbindungsleitungen 6 so ausgelegt, dass die Leitungsimpedanzen den Anforderungen des jeweiligen Standards entsprechen. Dabei sollten stets die gesamten Längen der Busverbindungsleitungen 6, also beispielsweise auch die Leitungslängen innerhalb der Prüfeinrichtung 4, Beachtung finden.

In einer ersten, in Fig. 1 dargestellten Ausführungsform ist der Träger 1 als eine Leiterplatte ausgeführt. Die Busverbindungsleitungen 6 sind mit den üblichen Herstellungsverfahren erzeugte Leiterbahnen, die fest mit dem Träger 1 verbunden sind. Unter Beachtung der zuvor genannten Erfordernisse der Hochgeschwindigkeits-Bussysteme stellen die Busverbindungsleitungen 6 eine starre Verbindung zwischen den elektrischen Kontakten des Prüfobjektsteckverbinders 31 und den benötigten elektrischen Kontakten des Prüfeinrichtungssteckverbinders 21 her.

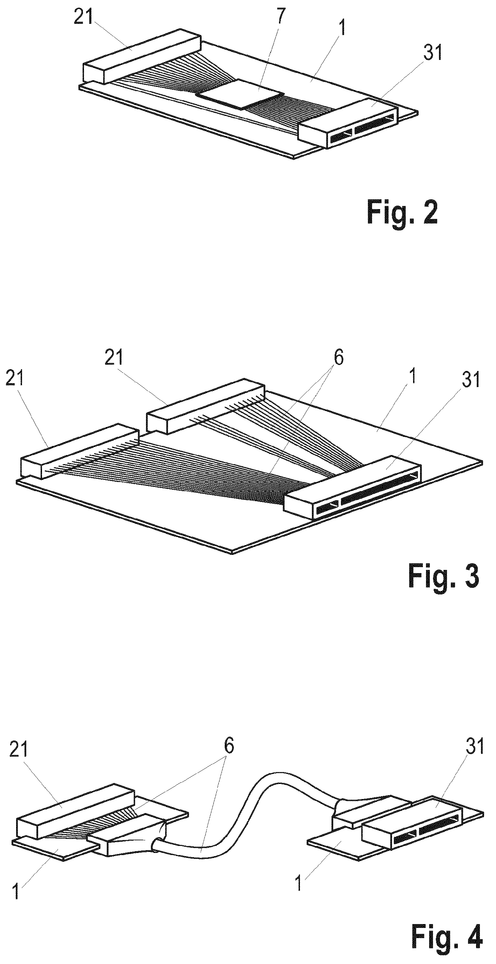

Um die Signalintegrität auf ein Höchstmaß zu steigern, weist der Schnittstellenadapter in einer zweiten, in Fig. 2 dargestellten Ausführungsform einen Signalverstärker 7 auf. Der Signalverstärker 7 ist in der Lage, Signale eines im jeweiligen Bussystem verwendeten Protokolls zu regenerieren und verstärkt weiterzugeben. Er kann auf der Leiterplatte des Schnittstellenadapters aus dem ersten Ausführungsbeispiel in die signalführenden Busverbindungsleitungen 6 integriert sein und ist besonders vorteilhaft am Prüfobjektsteckverbinder 31 oder in unmittelbarer Nähe des Prüfobjektsteckverbinders 31 angeordnet.

Die Fig. 3 zeigt eine dritte Ausführungsform des Schnittstellenadapters. Der Schnittstellenadapter ist hier um weitere Prüfeinrichtungssteckverbinder 21 erweitert. Wie bereits erwähnt, verfügt die Prüfeinrichtung 4 über eine oder mehrere identische Schnittstellen. Dementsprechend ist der Schnittstellenadapter ebenfalls mit zwei oder weiteren Prüfeinrichtungssteckverbindern 21 ausgestattet. Durch das Erweitern auf weitere Prüfeinrichtungssteckverbinder 21 können auch Schnittstellen mit höherer Bandbreite des Gbit-Busses mittels des Schnittstellenadapters geprüft werden. Während beispielsweise eine Verbindung nach USB 3.0 oder PCIe (1x) mit der oben beschriebenen Mindestbelegung einer Schnittstelle der Prüfeinrichtung 4 abgedeckt werden kann, sind für PCIe (4x) eine weitere und für PCIe (16x) drei weitere Schnittstellen erforderlich.

Die Verwendung weiterer Prüfeinrichtungssteckverbinder 21 eröffnet außerdem die Möglichkeit, bei der Verlegung der Busverbindungsleitungen 6 auf dem Schnittstellenadapter eine größere Variabilität zu erreichen. Dadurch entstehen mehr Freiheitsgrade, durch die das Einhalten der Erfordernisse von Hochgeschwindigkeits-Bussystemen deutlich erleichtert wird.

In einer weiteren Ausführung ist der Schnittstellenadapter dazu geeignet, eine begrenzte Entfernung zwischen der Prüfeinrichtung 4 und dem Prüfobjekt 5 zu überbrücken. Wie in Fig.4 gezeigt, ist dazu zumindest ein Teil der Busverbindungsleitungen 6 in Form einer flexiblen Verbindung zwischen der frei konfigurierbaren Schnittstelle 2 und der individuellen Schnittstelle 3 ausgeführt. Zur Reduzierung möglicher Störeinflüsse werden für die Busverbindungsleitungen 6 der flexiblen Verbindung nur optimierte Materialien und eine besonders hochwertige Abschirmung verwendet. Die Länge der flexiblen Busverbindungsleitungen 6 ist möglichst gering gehalten und richtet sich nach den Standards für die zu übertragende Datenrate. Die Längen sind ausreichend, um z. B. an einer Prüfstation in einer Fertigungslinie den Abstand zu einem auf dem Fließband liegenden Prüfobjekt 5 zu überbrücken. Ein derartiger Schnittstellenadapter besteht aus einem geteilten Träger 1, wobei ein Teil den Prüfeinrichtungssteckverbinder 21 trägt und der andere Teil den Prüfobjektsteckverbinder 31 trägt. Besonders vorteilhaft ist in dieser Ausführung die Verwendung eines Signalverstärkers 7 (in Fig. 4 nicht gezeigt), der auf dem Träger des Prüfobjektsteckverbinders 31 verbaut ist und die Signale für die Übertragung über die begrenzten Entfernungen verstärkt.

Der Schnittstellenadapter ermöglicht eine einfache und kostengünstige Anpassung zwischen einer Prüfeinrichtung 4 und einem Prüfobjekt 5 zur Prüfung einer Gbit-Busverbindung auf Fertigungsfehler und dynamische Beeinflussungen bei hohen Taktraten. Durch den Schnittstellenadapter erfolgt die Anpassung unabhängig von der Auslegung der Prüfeinrichtung 4. Dadurch werden eine Reihe von Vorteilen erzielt. So ist es möglich, auch Prüfobjekte 5 zu testen, deren Schnittstelle nicht den üblichen Standards entspricht. Außerdem kann durch eine Anpassung des Schnittstellenadapters auch auf Änderungen an der Prüfeinrichtung 4 reagiert werden, die sich aus möglichen technischen Weiterentwicklungen ergibt. Insbesondere bei der Verwendung der Prüfeinrichtung 4 in der Serienfertigung von Prüfobjekten 5 wird der Verschleiß durch häufiges Stecken und Ziehen der Prüfeinrichtungssteckverbinder 21 von der Prüfeinrichtung 4 auf den leicht austauschbaren Schnittstellenadapter verlagert.

### Bezugszeichenliste

- 1: Träger
- 2: frei konfigurierbare Schnittstelle
- 21: Prüfeinrichtungssteckverbinder
- 3: individuelle Schnittstelle
- 31: Prüfobjektsteckverbinder
- 4: Prüfeinrichtung
- 5: Prüfobjekt
- 6: Busverbindungsleitungen
- 7: Signalverstärker

## Patentansprüche

1. Gbit-Schnittstellenadapter zum Adaptieren von Gbit-Schnittstellen während eines Leitungstests eines Hochgeschwindigkeitsbusses eines Prüfobjekts (5) an eine Prüfeinrichtung (4), enthaltend einen Träger (1) mit einer Vielzahl mit Schnittstellen der Prüfeinrichtung (4) verbindbarerer elektrischer Kontakte als eine frei konfigurierbare Schnittstelle (2) und mit einer den Kontakten des zu prüfenden Prüfobjekts (5) entsprechenden Anzahl elektrischer Kontakte, wobei der Schnittstellenadapter eine Vielzahl Busverbindungsleitungen (6) zwischen der frei konfigurierbaren Schnittstelle (2) und den elektrischen Kontakten zur Anbindung des Prüfobjekts (5) aufweist, **dadurch gekennzeichnet, dass** die Vielzahl der Busverbindungsleitungen (6) des Schnittstellenadapters eine festgelegte, genau spezifizierte Leitungseigenschaften aufweisende Verbindung zwischen der frei konfigurierbaren Schnittstelle (2) und einer individuellen Schnittstelle (3) mit einer Anzahl der dem Prüfobjekt (5) entsprechenden elektrischen Kontakte herstellend auf dem Träger (1) angeordnet sind.

2. Gbit-Schnittstellenadapter nach Anspruch 1, **dadurch gekennzeichnet, dass** der Schnittstellenadapter einen integrierten Signalverstärker (7) zur Wahrung der Signalintegrität aufweist.

3. Gbit-Schnittstellenadapter nach Anspruch 1, **dadurch gekennzeichnet, dass** die Leitungseigenschaften einen maximalen Leitungsimpedanzunterschied entsprechend eines die jeweilige Schnittstelle definierenden Standards aufweisen.

4. Gbit-Schnittstellenadapter nach Anspruch 1, **dadurch gekennzeichnet, dass** die Leitungseigenschaften einen maximalen Leitungslängenunterschied entsprechend eines die jeweilige Schnittstelle definierenden Standards aufweisen.

5. Gbit-Schnittstellenadapter nach Anspruch 1, **dadurch gekennzeichnet, dass** die Leitungseigenschaften einen Leitungsverlauf mit einem Design frei von Störquellen entsprechend eines die jeweilige Schnittstelle definierenden Standards aufweisen.

6. Gbit-Schnittstellenadapter nach einem der vorhergehenden Ansprüche, **dadurch gekennzeichnet, dass** die Busverbindungsleitungen (6) des Schnittstellenadapters als eine flexible Verbindung ausgeführt sind.

7. Gbit-Schnittstellenadapter nach Anspruch 1, **dadurch gekennzeichnet, dass** die Busverbindungsleitungen (6) elektrische Verbindungen zur Übertragung von Spannungen, Strömen, Daten oder Signalen sind.

8. Gbit-Schnittstellenadapter nach Anspruch 1, **dadurch gekennzeichnet, dass** die individuelle Schnittstelle (3) und die Busverbindungsleitungen (6) mindestens Erfordernissen des jeweiligen Standards, z. B. USB 3.0, SATA II oder PCIe Gen2, entsprechen.

9. Gbit-Schnittstellenadapter nach Anspruch 1, **dadurch gekennzeichnet, dass** die frei konfigurierbare Schnittstelle (2) eine parallele Erweiterungsmöglichkeit zur Erhöhung einer Busbandbreite aufweist.
